# DEMANDE DE BREVET EUROPEEN

(11) **EP 2 234 260 A1**
(43) Date de publication de la demande: **29.09.2010**
(21) Numéro de dépôt: 10305137.1
(22) Date de dépôt: 10.02.2010
(51) Int. Cl.: H02M 7/00, H02M 1/00

(54) **Convertisseur électronique de puissance.**

(30) Priorité: 18.02.2009 FR 0951053
(71) Demandeur: Converteam Technology Ltd, Rugby Warwickshire CV21 1BU (GB)
(72) Inventeur: Lapassat, Nicolas, 91140 Villebon sur Yvette (FR); Baviere, Cyrille, 91120 Palaiseau (FR)
(74) Mandataire: Blot, Philippe Robert Emile

(57) **Abrégé**

Le convertisseur électronique de puissance comporte au moins un banc de condensateur continu et un onduleur de tension (4), dans lequel l'onduleur comporte au moins trois modules de phase (6), reliés entre eux, chacun propre à la mise en forme du courant sur une phase en sortie de l'onduleur de tension (4), et dans lequel le banc de condensateurs continu est relié aux modules de phase (6). Les modules de phase (6) de l'onduleur de tension (4) sont angulairement répartis autour d'un axe pour délimiter entre eux un espace cylindrique (10), les modules de phase (6) étant reliés entre eux par des éléments de connexion (22, 24, 26, 28) disposés à l'intérieur de l'espace cylindrique (10) délimité par les modules de phase (6). Le banc de condensateurs continu est relié aux modules de phase (6) par les éléments de connexion (22, 24, 26, 28) disposés à l'intérieur de l'espace cylindrique (10) délimité par les modules de phase (6).

## Description

La présente invention concerne un convertisseur électronique de puissance comportant au moins un banc de condensateurs continu et un onduleur de tension, dans lequel l'onduleur de tension comporte au moins trois modules de phase, reliés entre eux, chacun propre à la mise en forme du courant sur une phase en sortie de l'onduleur de tension, et dans lequel le banc de condensateurs continu est relié aux modules de phase.

On connaît des convertisseurs de ce type, implantés dans des armoires parallélépipédiques. Ces convertisseurs comportent un onduleur de tension comprenant n modules de phase, un module étant prévu pour chaque phase du courant afin de définir la forme du courant à transmettre en sortie de l'onduleur. Ces modules sont alignés et les potentiels continus d'alimentation des différents modules sont reliés entre eux par un bus laminé de faible inductance, qui est rectiligne du fait de l'alignement des modules de phase. De telles armoires parallélépipédiques sont relativement encombrantes et peu pratiques dans un milieu imposant la miniaturisation comme le milieu sous marin, qui implique notamment une implantation dans une enceinte de faible poids et de dimensions réduites.

La présente invention vise à proposer un convertisseur dont la structure permet l'implantation dans une enceinte de taille réduite.

A cet effet, l'invention a pour objet un convertisseur électronique de puissance du type précité, **caractérisé en ce que** les modules de phase de l'onduleur de tension sont angulairement répartis autour d'un axe pour délimiter entre eux un espace cylindrique, les modules de phase étant reliés entre eux par des éléments de connexion disposés à l'intérieur de l'espace cylindrique délimité par les modules de phase, et en ce que le banc de condensateurs continu est relié aux modules de phase par l'intermédiaire des éléments de connexion disposés à l'intérieur de cet espace cylindrique délimité par les modules de phase.

Un tel convertisseur peut être implanté dans une enceinte cylindrique, et permet en outre, par la disposition des différents éléments, une symétrie des impédances de connexion.

Selon différentes caractéristiques de la présente invention :
- les modules de phase de l'onduleur de tension sont régulièrement répartis angulairement autour de l'axe de l'espace cylindrique formé par les modules de phase.
- chaque module de phase de l'onduleur de tension comporte au moins un transistor et deux condensateurs de découplage.
- les condensateurs de découplage présentent un pôle positif, un pôle positif/neutre, un pôle neutre/négatif et un pôle négatif, et les pôles positifs sont reliés à un premier élément de connexion, les pôles positifs/neutres sont reliés à un deuxième élément de connexion, les pôles neutres/négatifs sont reliés à un troisième élément de connexion, et les pôles négatifs sont reliés à un quatrième élément de connexion.
- le banc de condensateurs continu comprend un pôle de tension positif, un pôle positif/neutre, un pôle neutre/négatif, et un pôle négatif, le pôle de tension positif étant relié au premier élément de connexion, le pôle positif/neutre étant relié au deuxième élément de connexion, le pôle neutre/négatif étant relié au troisième élément de connexion, le pôle négatif étant relié au quatrième élément de connexion, et le banc de condensateurs continu est dans le prolongement de l'espace cylindrique délimité par les modules de phase.
- un premier circuit d'amortissement, composé d'au moins une résistance et un condensateur, est relié en entrée au premier élément de connexion, et relié en sortie au deuxième élément de connexion, un deuxième circuit d'amortissement, composé d'au moins une résistance et un condensateur, est relié en entrée au troisième élément de connexion, et relié en sortie au quatrième élément de connexion, et les deux circuits d'amortissement sont disposés dans l'espace cylindrique délimité par les modules de phase.
- chaque module de phase de l'onduleur de tension comporte au moins un transistor et un condensateur de découplage.
- le condensateur de découplage présente un pôle positif et un pôle négatif, le pôle positif est relié à un premier élément de connexion et le pôle négatif est relié à un deuxième élément de connexion.
- le banc de condensateurs continu comprend un pôle de tension positif et un pôle négatif, le pôle de tension positif étant relié au premier élément de connexion et le pôle négatif étant relié au deuxième élément de connexion, et le banc de condensateurs continu est dans le prolongement de l'espace cylindrique délimité par les modules de phase.
- un premier circuit d'amortissement, composé d'au moins une résistance et un condensateur, est relié en entrée au premier élément de connexion, en sortie au deuxième élément de connexion, et le circuit d'amortissement est disposé dans l'espace cylindrique délimité par les modules de phase.
- les éléments de connexion sont formés d'un polygone à n côtés, où n est le nombre de modules de phase.
- l'onduleur de tension comporte trois modules de phase, et les éléments de connexion sont des éléments triangulaires.
- l'onduleur et le banc de condensateurs continu sont fixés mécaniquement sur une structure de support en treillis.
- la structure de support présente une forme hexagonale, de sorte qu'une face de cette structure est parallèle à chacun des modules de phase.
- la structure de support en treillis est fixée mécaniquement sur une enveloppe étanche.

L'invention va maintenant être décrite plus en détails, seulement à titre d'exemple et de façon non limitative, en regard des figures annexées et dans lesquelles :
- la figure 1 est une représentation d'ensemble d'un convertisseur selon un premier mode de réalisation de l'invention ;
- la figure 2 est une vue de dessus de l'onduleur du convertisseur de la figure 1 ;
- la figure 3 est une vue en perspective de l'onduleur de la figure 2 ;
- la figure 4 est un schéma électrique représentatif de la connexion de l'onduleur dans un convertisseur selon l'invention, pour une topologie à trois niveaux ;
- la figure 5 est une représentation schématique du convertisseur selon l'invention et de l'enveloppe étanche qui l'entoure ;
- la figure 6 est un schéma électrique équivalent à celui de la figure 4, pour une topologie à deux niveaux.

Un convertisseur électronique de puissance 1 selon l'invention est destiné par exemple à être relié à un moteur électrique, pour son alimentation. Un tel moteur peut notamment être utilisé pour un compresseur immergé de forte profondeur.

Le convertisseur comprend un banc de condensateurs continu 2 et un onduleur de tension 4, cet ensemble étant destiné à fournir l'énergie nécessaire au fonctionnement du moteur entraîné en sortie de l'onduleur. En entrée du banc de condensateur, le convertisseur comporte un dispositif redresseur non représenté propre à recevoir une tension d'un réseau d'alimentation et à transformer cette tension en un courant continu qui est stocké et filtré dans le banc de condensateurs continu 2. L'onduleur de tension 4 est propre à transformer cette tension continue en tension alternative à fréquence variable, pour alimenter les différentes phases du moteur électrique.

L'onduleur de tension 4 est formé de n modules de phase 6, chacun de ces modules étant associé à une des n phases du moteur électrique relié au convertisseur. Dans l'exemple considéré, le moteur a trois phases.

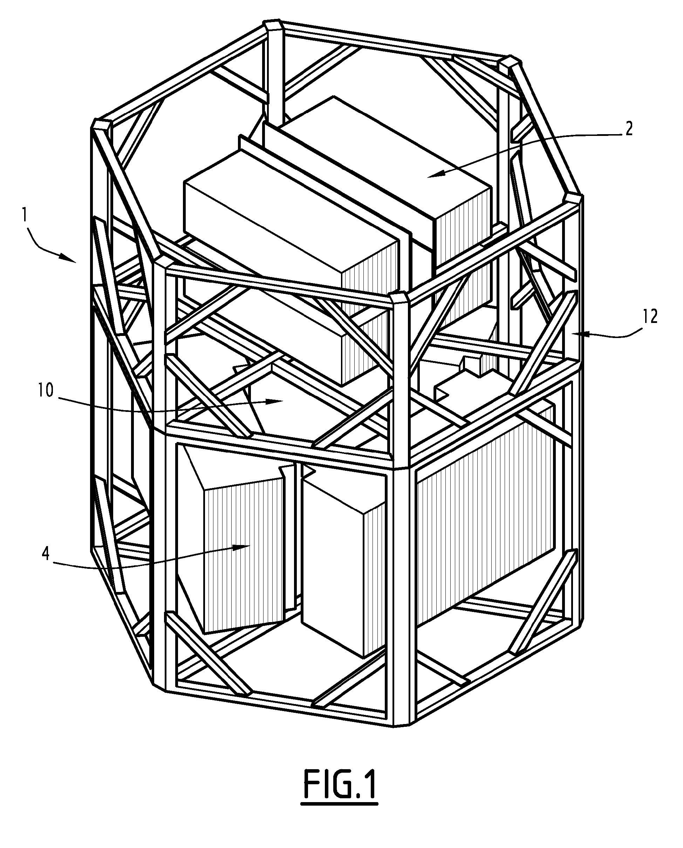

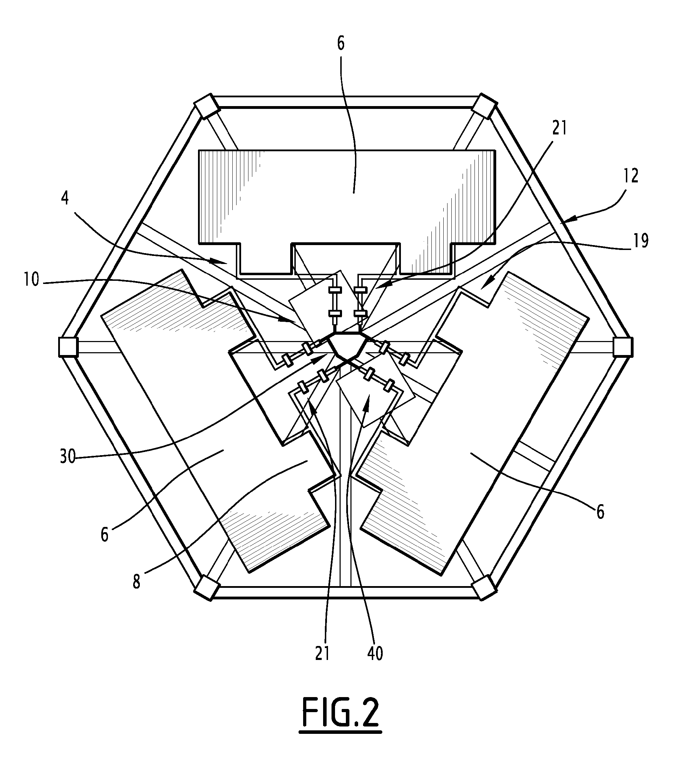

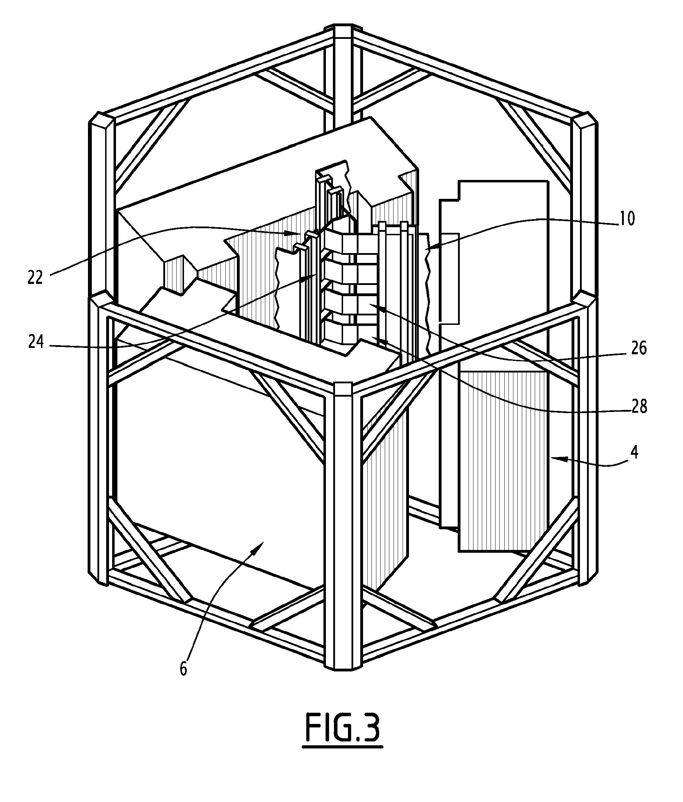

Le convertisseur selon l'invention peut présenter des topologies d'onduleurs à deux niveaux, à trois niveaux ou plus. La description qui va suivre, comme illustré par les figures 1 à 4, est relative à une topologie d'onduleurs à trois niveaux.

Chaque module de phase 6 est un sous ensemble comprenant au moins un transistor 7 et deux condensateurs de découplage 8. Une entrée de courant continu est formée aux bornes des condensateurs de découplage 8. Les condensateurs de découplage 8 sont disposés dans les modules de phase 6 pour stabiliser la tension continue entrant dans l'onduleur de tension 4, en provenance du banc de condensateurs continu.

Selon la présente invention, les modules de phase 6 de l'onduleur de tension 4 sont disposés circulairement, espacés l'un de l'autre par un angle déterminé. A des fins de compréhension de l'invention, un mode de réalisation a été représenté sur les figures avec trois modules de phase, espacés d'un angle de 120 degrés. Tel que représenté sur les figures 1 à 4, les trois modules de phase 6 de l'onduleur de tension 4 sont ainsi régulièrement répartis autour d'un axe pour délimiter entre eux un espace cylindrique 10, de base triangulaire formée par ces trois modules.

L'onduleur de tension 4 est intégré dans une structure de support 12 en treillis, de forme extérieure hexagonale, et recouverte par une enveloppe étanche 13 formant une enceinte étanche supportant la pression marine à la profondeur d'utilisation. La disposition des modules de phase 6 dans la structure de support 12 est telle qu'une face sur deux de la forme hexagonale de l'enveloppe s'étend parallèlement à et devant chacun des modules de phase 6. Les modules de phase 6 sont fixés sur cette structure en treillis.

Les condensateurs de découplage 8 de chaque module de phase 6 sont reliés entre eux, et sont reliés au banc de condensateurs continu 2, à l'arrière des modules 6, par des éléments de connexion placés au centre de l'espace cylindrique 10 délimité par les modules de phase 6.

Il y a selon l'invention autant d'éléments de connexion que de bornes distinctes dans les condensateurs de découplage 8 de chaque module de phase 6. Dans l'exemple de réalisation représenté, les condensateurs de découplage 8 présentent quatre bornes de connexion et quatre éléments de connexion sont disposés au centre de l'espace cylindrique 10 délimité par les modules de phase 6.

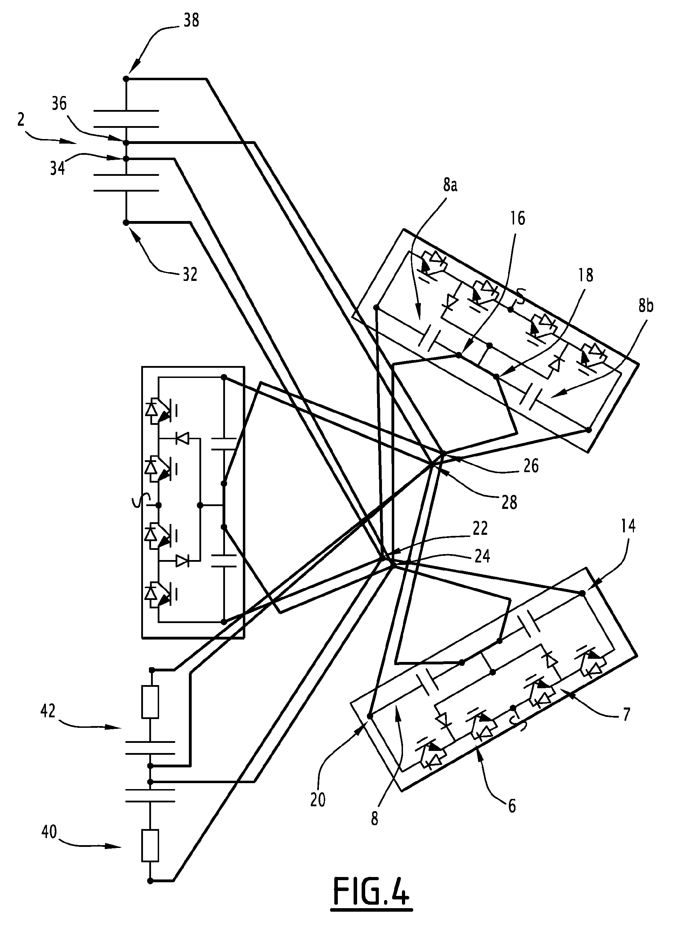

Comme illustré en détail sur la figure 4, dans chaque module de phase 6, un premier condensateur de découplage 8a comporte une borne de polarité positive 14 et une borne de polarité positive/neutre 16, tandis que le deuxième condensateur de découplage 8b comporte une borne de polarité neutre/négative 18 et une borne de polarité négative 20. La polarité neutre est ainsi répartie sur deux bornes distinctes pour faciliter la mise en regard des polarités positive et neutre d'une part, et des polarités négative et neutre d'autre part, entre les condensateurs de découplage 8 et les éléments de connexion.

Chaque module de phase 6 comprend quatre transistors 7 reliés en série et connectés dans le même sens, aux bornes desquels sont connectés des diodes montés en anti-parallèle. Une extrémité de cette série de transistor est reliée à la borne 14 et l'autre extrémité de cette série de transistors est reliée à la borne 20. Deux diodes sont montées en série sur un circuit de dérivation, dont une première extrémité est reliée entre le premier et le second transistor de la série, et dont l'autre extrémité est reliée entre le troisième et le quatrième transistor de la série. Une branche centrale relie les bornes de polarités neutres 16, 18 au circuit de dérivation, entre les deux diodes.

Des plaques 19 relient chacune des bornes des condensateurs de découplage 8 à l'élément de connexion correspondant. Des entretoises 21 permettent le rapprochement, sans contact, des plaques formant la polarité positive et la polarité neutre, et des entretoises 21' permettent le rapprochement, sans contact, des plaques formant la polarité négative et la polarité neutre. Ce rapprochement des plaques rend aselfique la connexion des condensateurs de découplage 8 aux éléments de connexion 22, 24, 26, 28.

La borne de polarité positive 14 est reliée à un premier élément de connexion 22, la borne de polarité positive/neutre 16 est reliée à un deuxième élément de connexion 24, la borne de polarité neutre/négative 18 est reliée à un troisième élément de connexion 26, et la borne de polarité négative 20 est reliée à un quatrième élément de connexion 28.

Chaque élément de connexion 22, 24, 26, 28 présente sensiblement la forme d'un triangle, chaque côté de ce triangle se prolongeant d'un côté pour former une étoile dont chaque branche est reliée à une plaque associée à une borne d'entrée donnée d'un module de phase 6. Ainsi, la borne de polarité positive des condensateurs de découplage du premier module de phase est relié à un premier côté du premier élément de connexion 22, la borne de polarité positive des condensateurs de découplage du deuxième module de phase est relié à un deuxième côté du premier élément de connexion 22, et la borne de polarité positive des condensateurs de découplage du troisième module de phase est relié à un troisième côté du premier élément de connexion 22.

Les éléments de connexion 22, 24, 26, 28 sont superposés, formant une colonne 30 au centre de l'espace cylindrique 10 délimité par les modules de phase 6.

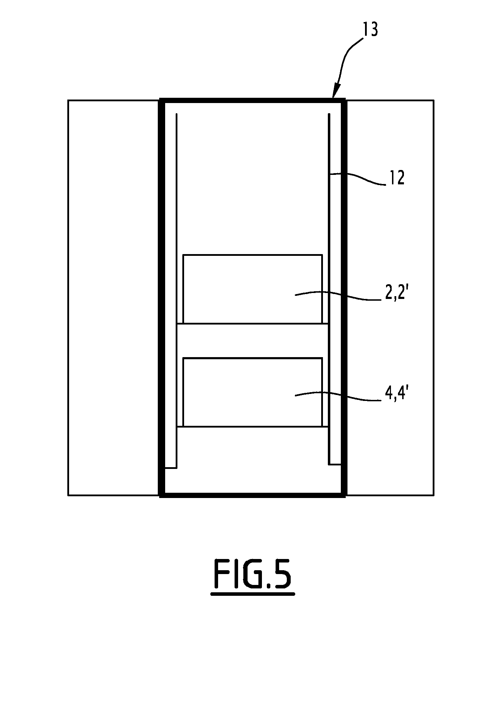

Le banc de condensateurs continu 2 est disposé dans le convertisseur électronique de puissance 1 selon l'invention, au dessus des modules de phase 6 de l'onduleur de tension 4. Ce banc de condensateurs continu 2 est contenu dans le prolongement supérieur de la structure de support 12 en treillis du convertisseur électronique 1, tel qu'illustré par la figure 5.

Le banc de condensateurs continu 2 délivre une tension continue. Il comprend une borne de polarité positive 32, une borne de polarité positive/neutre 34, une borne de polarité neutre/négative 36, et une borne de polarité négative 38. La borne de polarité positive 32 est reliée au premier élément de connexion 22, la borne de polarité positive/neutre 34 est reliée au deuxième élément de connexion 24, la borne de polarité neutre/négative 36 est reliée au troisième élément de connexion 26, et la borne de polarité négative 38 est reliée au quatrième élément de connexion 28.

La connexion du banc de condensateurs continu 2 aux modules de phase 6 est effectuée via les éléments de connexion 22, 24, 26, 28, par un premier faisceau de câbles reliant les polarités positive et positive/neutre du banc de condensateurs continu aux premier et deuxième éléments de connexion, et par un deuxième faisceau de câbles reliant les polarités négative et neutre/négative du banc de condensateurs continu aux troisième et quatrième éléments de connexion. Ces faisceaux sont entremêlés et présentent ainsi entre eux une grande surface en regard l'un de l'autre. La liaison obtenue est ainsi de faible induction et permet de rendre aussi aselfique que possible la connexion entre les condensateurs de découplage 8 et le banc de condensateurs continu 2, afin de limiter les oscillations.

Un premier circuit d'amortissement 40, composé d'au moins une résistance et un condensateur en série, est relié en entrée au premier élément de connexion 22, et relié en sortie au deuxième élément de connexion 24. Un deuxième circuit d'amortissement 42, composé d'au moins une résistance et un condensateur, est relié en entrée au troisième élément de connexion 26, et relié en sortie au quatrième élément de connexion 28. Ces circuits d'amortissement 40, 42, qui permettent d'amortir des oscillations, sont disposés dans l'espace cylindrique 10 délimité par les modules de phase 6.

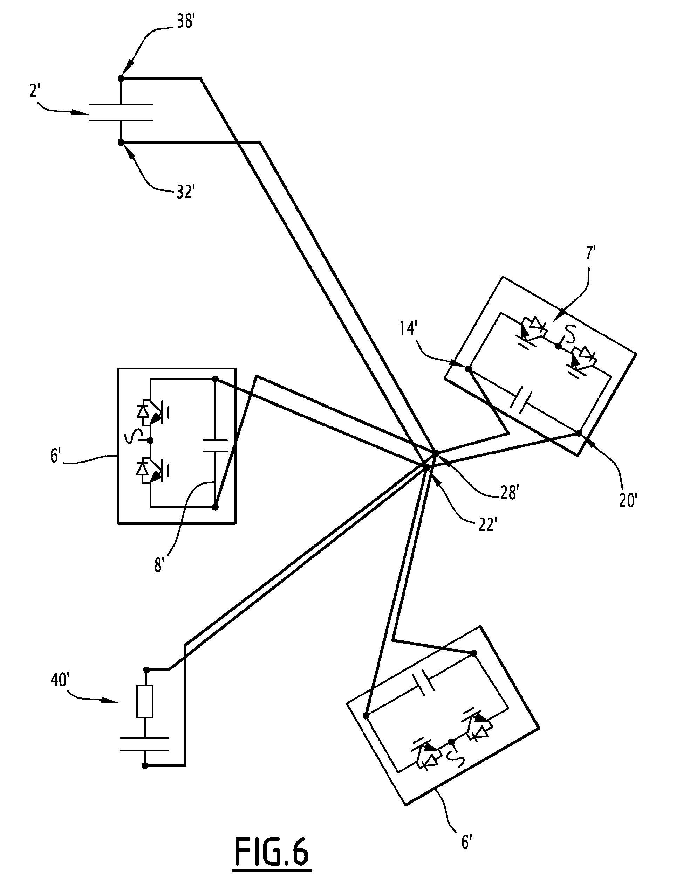

Comme illustré par la figure 6, l'invention s'applique également aux topologies d'onduleurs à deux niveaux. Chaque module de phase 6' est un sous ensemble comprenant au moins un transistor 7' et un condensateur de découplage 8'. Dans chaque module de phase 6', le condensateur de découplage 8' comporte une borne de polarité positive 14' et une borne de polarité négative 20'. Deux transistors 7', aux bornes desquels sont connectés des diodes montées en anti-parallèle, sont reliés en série et connectés dans le même sens. Une extrémité de cette série de transistor est reliée à la borne 14' et l'autre extrémité de cette série de transistors est reliée à la borne 20'.

La borne de polarité positive 14' est reliée à un premier élément de connexion 22', et la borne de polarité négative 20' est reliée à un deuxième élément de connexion 28'. Le banc de condensateur continu 2' comprend une borne de polarité positive 32' et une borne de polarité négative 38'. La borne de polarité positive 32' est reliée au premier élément de connexion 22', et la borne de polarité négative 38' est reliée au deuxième élément de connexion 28'. Un circuit d'amortissement 40' est relié en entrée au premier circuit d'amortissement 22', et en sortie au deuxième circuit d'amortissement 28'.

Dans les applications immergées en milieu sous marin les enveloppes étanches 13 entourant le convertisseur sont conçues avec une section réduite par rapport à la hauteur, afin de limiter l'épaisseur de paroi de l'enveloppe sous-marine, et donc le poids de cette enveloppe. Ce poids est prépondérant dans le poids total du convertisseur et induit des contraintes pouvant être déterminante sur le plan logistique. L'implantation d'un onduleur optimisant le volume cylindrique disponible est un atout pour ce type d'application.

Le banc de condensateurs continu 2 et l'onduleur de tension 4 sont fixés mécaniquement sur la structure de support en treillis 12, qui est fixée mécaniquement sur l'enveloppe étanche 13 qui tient la pression de l'eau.

La structure de support en treillis 12 permet la fixation des modules de phase 6. A l'intérieur de cette structure en treillis 12, la disposition spécifique des modules de phase 6 génère un espace libre permettant la mise en place des éléments de connexion 22, 24, 26, 28 de ces modules de phase.

L'invention s'applique à tout type de convertisseur, quelle que soit la topologie des phases de l'onduleur, dès lors que les modules de phase de l'onduleur forment un cylindre à l'intérieur duquel sont interconnectés les pôles des condensateurs de découplage de cet onduleur.

Le fait que l'interconnexion des modules de phase 6 décrite ci-dessus soit réalisée à l'intérieur de l'espace cylindrique 10 délimité par ces modules de phase 6 permet de rendre cette interconnexion symétrique et compacte. Les condensateurs de découplage 8 montés directement dans les modules de phase 6 sont ainsi rapprochés les uns des autres, contrairement à une disposition rectiligne dans laquelle un condensateur de découplage peut se retrouver à des distances variables des autres condensateurs de découplage. Cela permet de réduire l'inductance d'interconnexion entre les condensateurs de découplage 8 rapprochés et permet donc de limiter les courants d'oscillation entre ces condensateurs 8, qui peuvent être une source d'échauffement limitant leur durée de vie.

Comme évoqué précédemment, la description ci-dessus a porté sur un mode de réalisation de l'invention constituée de trois modules de phases disposés à 120 degrés. Mais la disposition angulairement régulière des modules de phase peut être mise en place pour un nombre de modules de phase distinct de trois. L'onduleur selon l'invention peut comprendre n modules de phase, avec n entier supérieur ou égal à trois, et ces n modules de phase sont alors disposés circulairement, espacés angulairement les uns des autres par un angle de 360/n degrés. Les éléments de connexion des modules de phase prennent alors une forme de polygone à n côtés, ou d'étoile à n branches, pour que chaque côté ou branche puisse être associé à l'un des modules, comme la forme triangulaire dans l'exemple de réalisation ci-dessus permet d'associer chacun des côtés à l'un des trois modules de phase. Cela permet à la fois de symétriser les impédances des connexions entre ces n modules de phase, et d'optimiser l'implantation dans le cylindre.

## Revendications

1. Convertisseur électronique de puissance (1), comportant au moins un banc de condensateurs continu (2) et un onduleur de tension (4), dans lequel l'onduleur de tension (4) comporte au moins trois modules de phase (6), reliés entre eux, chacun propre à la mise en forme du courant sur une phase en sortie de l'onduleur de tension (4), et dans lequel le banc de condensateurs continu (2) est relié aux modules de phase (6, 6'), dans lequel les modules de phase (6, 6') de l'onduleur de tension (4) sont angulairement répartis autour d'un axe pour délimiter entre eux un espace cylindrique (10), les modules de phase (6, 6') étant reliés entre eux par des éléments de connexion (22, 22', 24, 26, 28, 28') disposés à l'intérieur de l'espace cylindrique (10) délimité par les modules de phase (6, 6'), dans lequel le banc de condensateurs continu (2) est relié aux modules de phase (6) par l'intermédiaire des éléments de connexion (22, 22', 24, 26, 28, 28') disposés à l'intérieur de cet espace cylindrique (10) délimité par les modules de phase (6, 6'),
**caractérisé en ce que** chaque module de phase (6) comporte au moins un condensateur de découplage (8 ; 8').

2. Convertisseur électronique de puissance (1) selon la revendication 1, **caractérisé en ce que** les modules de phase (6, 6') de l'onduleur de tension (4) sont régulièrement répartis angulairement autour de l'axe de l'espace cylindrique (10) formé par les modules de phase (6, 6').

3. Convertisseur électronique de puissance (1) selon l'une des revendications 1 ou 2, **caractérisé en ce que** chaque module de phase (6) de l'onduleur de tension (4) comporte au moins un transistor et deux condensateurs de découplage (8).

4. Convertisseur électronique de puissance (1) selon la revendication 3, **caractérisé en ce que** les condensateurs de découplage (8) présentent un pôle positif (14), un pôle positif/neutre (16), un pôle neutre/négatif (18) et un pôle négatif (20), et **en ce que** les pôles positifs (14) sont reliés à un premier élément de connexion (22), les pôles positifs/neutres (16) sont reliés à un deuxième élément de connexion (24), les pôles neutres/négatifs (18) sont reliés à un troisième élément de connexion (26), et les pôles négatifs (20) sont reliés à un quatrième élément de connexion (28).

5. Convertisseur électronique de puissance (1) selon la revendication 4, **caractérisé en ce que** le banc de condensateurs continu (2) comprend un pôle de tension positif (32), un pôle positif/neutre (34), un pôle neutre/négatif (36), et un pôle négatif (38), le pôle de tension positif (32) étant relié au premier élément de connexion (22), le pôle positif/neutre (34) étant relié au deuxième élément de connexion (24), le pôle neutre/négatif (36) étant relié au troisième élément de connexion (26), et le pôle négatif (38) étant relié au quatrième élément de connexion (28), et **caractérisé en ce que** le banc de condensateurs continu (2) est dans le prolongement de l'espace cylindrique (10) délimité par les modules de phase (6).

6. Convertisseur électronique de puissance (1) selon la revendication 4 ou 5, **caractérisé en ce qu'**un premier circuit d'amortissement (40, 40'), composé d'au moins une résistance et un condensateur, est relié en entrée au premier élément de connexion (22), et relié en sortie au deuxième élément de connexion (24), **en ce qu'**un deuxième circuit d'amortissement (42), composé d'au moins une résistance et un condensateur, est relié en entrée au troisième élément de connexion (26), et relié en sortie au quatrième élément de connexion (28), et **en ce que** les deux circuits d'amortissement (40, 42) sont disposés dans l'espace cylindrique (10) délimité par les modules de phase (6).

7. Convertisseur électronique de puissance (1) selon l'une des revendications 1 ou 2, **caractérisé en ce que** chaque module de phase (6') de l'onduleur de tension (4) comporte au moins un transistor et un condensateur de découplage (8').

8. Convertisseur électronique de puissance (1) selon la revendication 7, **caractérisé en ce que** le condensateur de découplage (8') présente un pôle positif (14') et un pôle négatif (20'), et **en ce que** le pôle positif (14') est relié à un premier élément de connexion (22'), et le pôle négatif (20') est relié à un deuxième élément de connexion (28').

9. Convertisseur électronique de puissance (1) selon la revendication 8, **caractérisé en ce que** le banc de condensateurs continu (2) comprend un pôle de tension positif (32') et un pôle négatif (38'), le pôle de tension positif (32') étant relié au premier élément de connexion (22') et le pôle négatif (38') étant relié au deuxième élément de connexion (28'), et **caractérisé en ce que** le banc de condensateurs continu (2) est dans le prolongement de l'espace cylindrique (10) délimité par les modules de phase (6') .

10. Convertisseur électronique de puissance (1) selon la revendication 8 ou 9, **caractérisé en ce qu'**un premier circuit d'amortissement (40'), composé d'au moins une résistance et un condensateur, est relié en entrée au premier élément de connexion (22'), et relié en sortie au deuxième élément de connexion (28'), et **en ce que** le circuit d'amortissement (40') est disposé dans l'espace cylindrique (10) délimité par les modules de phase (6').

11. Convertisseur électronique de puissance (1) selon l'une quelconque des revendications précédentes, **caractérisé en ce que** les éléments de connexion (22, 22', 24, 26, 28, 28') sont formés d'un polygone à n côtés, où n est le nombre de modules de phase (6, 6').

12. Convertisseur électronique de puissance (1) selon la revendication précédente, **caractérisé en ce que** l'onduleur de tension (4) comporte trois modules de phase (6, 6'), et **en ce que** les éléments de connexion (22, 22', 24, 26, 28, 28') sont des éléments triangulaires.

13. Convertisseur électronique de puissance (1) selon l'une quelconque des revendications précédentes, **caractérisé en ce que** l'onduleur (4) et le banc de condensateurs continu (2) sont fixés mécaniquement sur une structure de support (12) en treillis.

14. Convertisseur électronique de puissance (1) selon la revendication 13, **caractérisé en ce que** la structure de support (12) présente une forme hexagonale, de sorte qu'une face de cette structure est parallèle à chacun des modules de phase (6, 6').

15. Convertisseur électronique de puissance (1) selon l'une des revendications 13 ou 14, **caractérisé en ce que** la structure de support (12) en treillis est fixée mécaniquement sur une enveloppe étanche (13).
